# EUROPÄISCHE PATENTANMELDUNG

(11) **EP 1 291 118 A1**
(43) Veröffentlichungstag der Anmeldung: **12.03.2003**
(21) Anmeldenummer: 01121424.4
(22) Anmeldetag: 07.09.2001
(51) Int. Cl.: B23K 26/40, B23K 26/10, H05K 3/00

(54) **Verfahren und Vorrichtung zum Vertiefen von Löchern in einer Mehrlagenleiterplatte**

(71) Anmelder: TRUMPF LASERTECHNIK GmbH, D-71254 Ditzingen (DE)
(72) Erfinder: Schwandt, Markus, 23617 Stockelsdorf (DE); Schulz, Joachim, 70193 Stuttgart (DE)
(74) Vertreter: KOHLER SCHMID + PARTNER

(57) **Zusammenfassung**

Bei einem Verfahren zum Vertiefen von Löchern (10), die in der äußeren Kupferschicht (7) einer Mehrlagenleiterplatte (6) vorgesehen sind, in eine angrenzende Dielektrikumschicht (9) hinein mittels eines die Dielektrikumschicht (9) abtragenden Laserstrahls (2) überstreicht erfindungsgemäß der Laserstrahl (2) die äußere Kupferschicht (7) zumindest nahezu vollflächig. Die zum Durchführen dieses Verfahrens geeignete Vorrichtung (1) umfaßt eine Ablenkeinrichtung, die den Laserstrahl (2) auf der äußeren Kupferschicht (7) bei einer während der Bearbeitung transportierten Mehrlagenleiterplatte (6) schräg zur Transportrichtung (16) oder bei einer während der Bearbeitung nicht transportierten Mehrlagenleiterplatte (6) zweidimensional ablenkt.

## Beschreibung

Die Erfindung betrifft ein Verfahren zum Vertiefen von Löchern, die in der äußeren Kupferschicht einer Mehrlagenleiterplatte (Multilayerplatine) vorgesehen sind, in eine angrenzende Dielektrikumschicht hinein mittels eines die Dielektrikumschicht abtragenden Laserstrahls sowie eine Vorrichtung zum Durchführen dieses Verfahrens.

Eine derartige Mehrlagenleiterplatte und ein derartiges Verfahren sind beispielsweise durch die DE 197 19 700 A1 bekannt geworden.

Aus der DE 197 19 700 A1 ist ein Verfahren zum Herstellen von Sacklöchern (sogenannte Microvia-Bohrungen) in einer Mehrlagenleiterplatte bekannt, die eine Durchkontaktierung zwischen zwei durch eine Dielektrikumschicht voneinander getrennten Kupferschichten ermöglichen. Dazu wird mittels eines ersten Lasers ein Loch in die die Außenseite der Mehrlagenleiterplatte bildende erste Kupferschicht eingebracht, das bis in die darunterliegende Dielektrikumschicht reicht. Bei dem ersten Laser handelt es sich um einen Nd:YAG-Dauerstrichlaser mit einer zum Abtragen von Kupfer geeigneten Wellenlänge von 355 nm, der im Riesenimpulsbetrieb mit Pulsbreiten zwischen 1 ns und 1 µs betrieben wird. Mittels eines zweiten Lasers wird das Loch in der Dielektrikumschicht bis zur zweiten Kupferschicht vertieft. Bei dem zweiten Laser handelt es sich ebenfalls um einen Nd:YAGoder einen CO₂-Laser mit einer im Vergleich zum ersten Laser größeren Wellenlänge im Bereich zwischen 1064 nm und 10600 nm, bei der die Laserstrahlung von Kupfer reflektiert wird. Der Durchmesser des vom zweiten Laser erzeugten Laserstrahls ist größer als im Falle des ersten Lasers, so daß die erste Kupferschicht mit dem darin ausgebildeten Loch als Blende wirkt und in der Dielektrikumschicht saubere Lochflanken erzeugt werden. Somit können die Anforderungen an die Fokussierbarkeit der Laserstrahlung und die Genauigkeit beim Positionieren der Mehrlagenleiterplatte erheblich gesenkt werden. Die zur Zeit erreichbaren Lochdurchmesser liegen zwischen 50 und 100 µm. Für dieses Verfahren ist es allerdings erforderlich, den zweiten Laser bei ausgeschaltetem Laserstrahl auf die in der äußeren Kupferschicht bereits ausgebildeten Öffnungen zu positionieren und erst dann den Laserstrahl einzuschalten.

Nach dem Bohrvorgang wird dann in einem Galvanisierungsprozeß Kupfer in den Löchern abgeschieden und somit der elektrische Kontakt zwischen den beiden Kupferschichten, d.h. zwischen den beiden Leiterbahnebenen, hergestellt.

Es ist die Aufgabe der Erfindung, bei einem Verfahren der eingangs genannten Art die zum Vertiefen von Löchern benötigte Bearbeitungszeit zu verkürzen sowie eine dafür geeignete Vorrichtung bereitzustellen.

Diese Aufgabe wird erfindungsgemäß dadurch gelöst, daß der Laserstrahl in mindestens einer, mindestens ein zu vertiefendes Loch überstreichenden Bahnkurve über die äußere Kupferschicht abgelenkt wird.

Diese Maßnahme hat den Vorteil, daß der Laserstrahl nicht exakt auf ein zu vertiefendes Loch positioniert werden muß und dauerhaft eingeschaltet bleiben kann.

Bevorzugt wird der Laserstrahl in mehreren, jeweils mindestens ein anderes zu vertiefendes Loch überstreichenden geradlinigen Bahnen über die äußere Kupferschicht abgelenkt. Besonders bevorzugt werden dabei die mehreren geradlinigen Bahnen des Laserstrahls dadurch erzeugt, daß ein Ablenkspiegel um stets den gleichen Freiheitsgrad ausgelenkt wird. Wenn die mehreren gradlinigen Bahnen auf der äußeren Kupferschicht parallel zueinander verlaufen, wird zur Vertiefung eines Loches der Laserstrahl schräg zur geradlinigen Bahn auf die Höhe des zu vertiefenden Loches positioniert und dann über die äußere Kupferschicht abgelenkt.

Wenn der Laserstrahl die äußere Kupferschicht zumindest nahezu vollflächig überstreicht bzw. abscannt, hängt die Bearbeitungszeit nicht von der Anzahl und der geometrischen Form der zu vertiefenden Löcher ab, sondern einzig von der überstrichenen Fläche. Insbesondere bei vielen zu vertiefenden Löchern wird im Vergleich zu den bisher bekannten Verfahren weniger Zeit benötigt, da die einzelnen Bohrpositionen nicht einzeln angefahren werden müssen.

Die Bahnkurven des Laserstrahls auf der äußeren Kupferschicht werden so gewählt, daß möglichst viele zu vertiefende Löcher auf einer Bahnkurve liegen. Wenn beispielsweise die zu vertiefenden Löcher auf zwei nicht parallelen Geraden liegen, wird der Laserstrahl entlang dieser beiden geradlinigen Bahnkurven abgelenkt.

In einer bevorzugten Verfahrensvariante wird der Laserstrahl in Richtung auf die äußere Kupferschicht zweidimensional abgelenkt. Dazu kann der Laserstrahl z.B. mittels zweier um zueinander nicht parallele Achsen verschwenkbarer Spiegel oder mittels eines um zwei zueinander nicht parallele Achsen verschwenkbaren Spiegels abgelenkt werden.

In einer anderen Verfahrensvariante wird die Mehrlagenleiterplatte am Laserstrahl vorbeitransportiert und der Laserstrahl schräg, also in jedem beliebigen Winkel, zur Transportrichtung der Mehrlagenleiterplatte abgelenkt.

Wenn die Geschwindigkeit, mit welcher der Laserstrahl die äußere Kupferschicht überstreicht, und die Leistung des Laserstrahls entsprechend aufeinander abgestimmt sind, können in der Dielektrikumschicht Löcher mit der gewünschten Lochtiefe in einem einzigen Überstreichungsvorgang ausgebildet werden.

Die oben genannte Aufgabe wird erfindungsgemäß auch durch eine Vorrichtung mit einem zum Abtragen der Dielektrikumschicht geeigneten Laserstrahl und mit einer Ablenkeinrichtung gelöst, die den Laserstrahl auf der äußeren Kupferschicht bei einer während der Bearbeitung transportierten Mehrlagenleiterplatte schräg zur Transportrichtung oder bei einer während der Bearbeitung nicht transportierten Mehrlagenleiterplatte zweidimensional ablenkt.

In einer bevorzugten Ausführungsform der erfindungsgemäßen Vorrichtung umfaßt die Ablenkeinrichtung einen rotierenden Polygonspiegel, der den Laserstrahl zumindest radial zur Rotationsachse ablenkt.

In alternativen Ausführungsformen umfaßt die Ablenkeinrichtung entweder einen um zwei nicht parallele Achsen auslenkbaren Ablenkspiegel oder zwei jeweils um eine Achse auslenkbare Ablenkspiegel, wobei die Achsen nicht parallel zueinander verlaufen.

Weitere Vorteile der Erfindung ergeben sich aus der Beschreibung und der Zeichnung. Ebenso können die vorstehend genannten und die noch weiter aufgeführten Merkmale erfindungsgemäß jeweils einzeln für sich oder zu mehreren in beliebigen Kombinationen Verwendung finden. Die gezeigte und beschriebene Ausführungsform ist nicht als abschließende Aufzählung zu verstehen, sondern hat vielmehr beispielhaften Charakter für die Schilderung der Erfindung.

Es zeigen:
- Fig. 1: schematisch die wesentlichen Komponenten einer zum Durchführen des erfindungsgemäßen Verfahrens geeigneten Vorrichtung, wobei die Mehrlagenleiterplatte in einer Schnittansicht gemäß I-I in Fig. 2 dargestellt ist; und
- Fign. 2 bis 6: jeweils unterschiedliche Lochbilder in der äußeren Kupferschicht und mögliche Bahnkurven des die äußere Kupferschicht überstreichenden Laserstrahls.

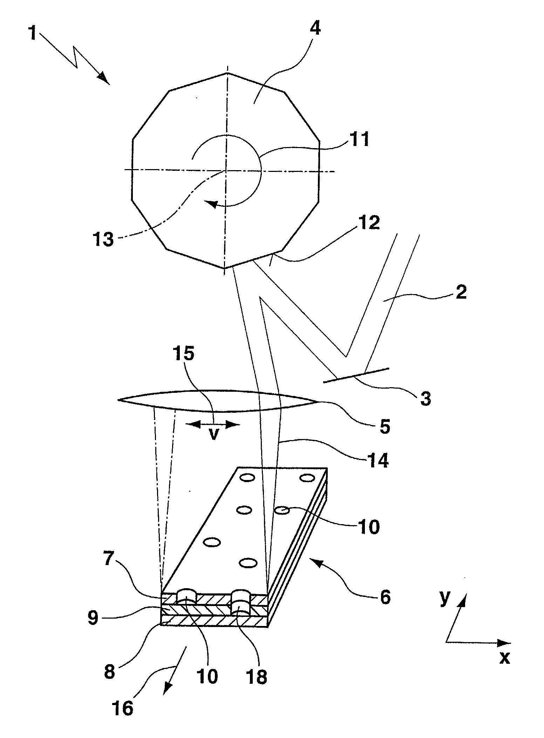

Die in **Fig. 1** gezeigte Vorrichtung **1** umfaßt einen Laser, dessen Laserstrahl **2** über einen Umlenkspiegel **3**, eine als rotierender Polygonspiegel **4** ausgebildete Ablenkeinrichtung und eine Linse **5** auf eine Mehrlagenleiterplatte **6** fokussiert wird. Die gezeigte Mehrlagenleiterplatte 6 hat zwei Kupferschichten **7**, **8** und eine dazwischenliegende Dielektrikumschicht **9** aus Epoxydharz oder aus faserverstärktem Epoxydharz. Die erste, äußere Kupferschicht 7 weist Löcher **10** mit Durchmesser zwischen 50 und 100 µm auf, die bis zur Dielektrikumschicht 9 reichen und auf bekannte Weise mittels eines Lasers oder in einem naßchemischen Ätzprozeß erzeugt worden sind. Die Gesamtdicke der gezeigten Schichtenfolge beträgt etwa 50 bis 300 µm, wobei sich an die zweite Kupferschicht 9 weitere Dielektrikum- und Kupferschichten anschließen können.

Bei dem Laser handelt es sich um einen Nd:YAG- oder einen CO₂-Laser mit einer Wellenlänge im Bereich zwischen 1064 nm und 11800 nm, bei der die Laserstrahlung von Kupfer reflektiert wird.

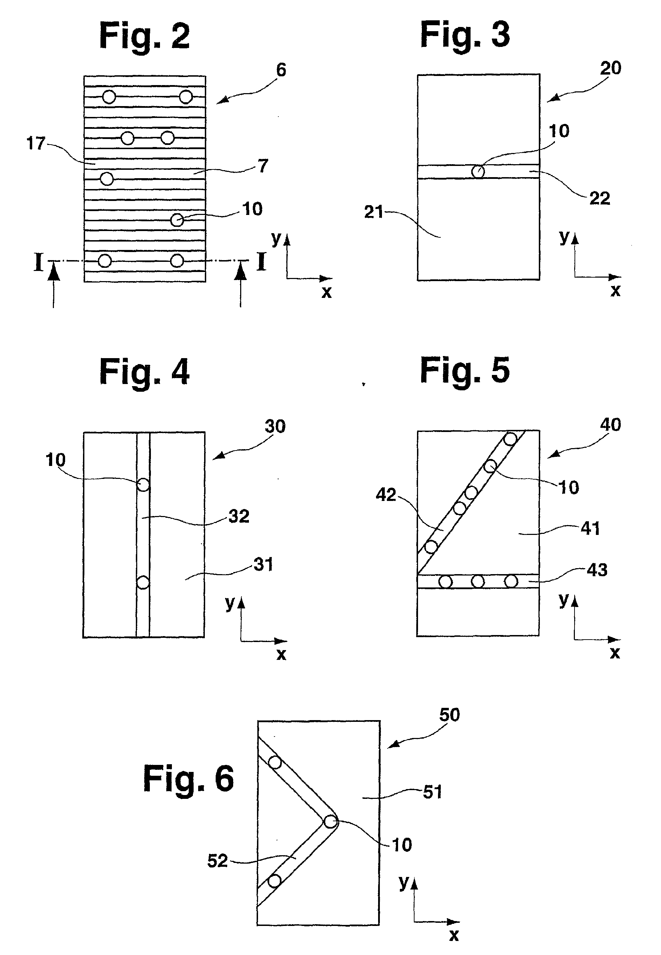

Der sich in Pfeilrichtung **11** drehende Polygonspiegel 4 reflektiert den auf eine seiner Spiegelflächen **12** auftreffenden Laserstrahl 2 radial zur Rotationsachse **13**, so daß der fokussierte Laserstrahl **14** (Fokusdurchmesser z.B. 100 µm) in Richtung des Doppelpfeils (X-Richtung) **15** über die gesamte Breite der Mehrlagenleiterplatte 6 abgelenkt wird. Indem die Mehrlagenleiterplatte 6 rechtwinklig zur Ablenkrichtung 15, also in Y-Richtung, am Laserstrahl 14 vorbeibewegt wird (Transportrichtung **16**), überstreicht bzw. scannt der Laserstrahl 14 die äußere Kupferschicht 7, wie in **Fig. 2** gezeigt ist, in parallelen Bahnen 17 vollflächig mit nahezu homogener Energiedichte ab. Die maximale Transportgeschwindigkeit der Mehrlagenleiterplatte 6 ergibt sich aus dem Fokusdurchmesser und der Scanngeschwindigkeit v des Laserstrahls 14 auf der äußeren Kupferschicht 7. Durch den Laserstrahl 14 wird das Loch 10 in die Dielektrikumschicht 9 hinein vertieft und dort ein Loch **18** mit einer bis zur zweiten Kupferschicht 8 reichenden Lochtiefe in einem einzigen Überstreichungsvorgang erzielt. Dabei wirkt die erste Kupferschicht 7 mit dem darin vorhandenen Loch 10 als Blende für den Laserstrahl 14. In der Fig. 1 ist die äußerst rechte Ablenkposition des Laserstrahls 14 dargestellt und die äußerst linke Ablenkposition strichpunktiert angedeutet. Nach dem Bohrvorgang wird in einem Galvanisierungsprozeß Kupfer in dem durch die Löcher 10, 18 gebildeten Sackloch abgeschieden und somit der elektrische Kontakt zwischen den beiden Kupferschichten 7, 8, d.h. zwischen den beiden Leiterbahnebenen, hergestellt.

Die Scanngeschwindigkeit v des Laserstrahls 14 ist derart gewählt, daß einerseits eine Wechselwirkung des Laserstrahls 14 mit dem Dielektrikummaterial erfolgt, aber andererseits die unter der äußeren Kupferschicht 7 liegende Dielektrikumschicht 9 durch Wärmeleitung über die Lochflanken nicht beschädigt wird. Bei geeigneter Wahl der Scanngeschwindigkeit v und der Leistung des Laserstrahls 14 können die Löcher 18 mit der gewünschten Lochtiefe in einem einzigen Scannvorgang erzeugt werden. Die Bearbeitungszeit hängt dabei nicht von der Anzahl und der geometrischen Form der zu vertiefenden Löcher 10 ab.

In einer nicht gezeigten, anderen Ausführungsform ist die Linse 5 nicht, wie in Fig. 1 gezeigt, nach der Ablenkeinrichtung, sondern davor angeordnet.

**Fig. 3** zeigt eine andere Mehrlagenleiterplatte **20**, deren äußere Kupferschicht **21** nur ein einziges zu vertiefendes Loch 10 aufweist. Die Mehrlagenleiterplatte 20 wird in der Vorrichtung 1 in Y-Richtung so weit bewegt, bis sich das Loch 10 auf der Höhe des fokussierten Laserstrahls 14 befindet. Dann wird der fokussierte Laserstrahl 14 in einer in X-Richtung verlaufenden geraden Bahn **22** über die gesamte Breite der Mehrlagenleiterplatte 20 abgelenkt und dabei das Loch 10 überstrichen.

Im folgenden werden weitere Bahnkurven eines Laserstrahls beschrieben, der mit einer anderen, nicht gezeigten Ablenkvorrichtung in X- und Y-Richtung unabhängig voneinander ablenkbar ist. Diese Ablenkvorrichtung umfaßt entweder einen in X- und Y-Richtung auslenkbaren Ablenkspiegel oder zwei um die X- bzw. Y-Richtung auslenkbare Ablenkspiegel.

**Fig. 4** zeigt eine weitere Mehrlagenleiterplatte **30**, deren äußere Kupferschicht **31** zwei in Y-Richtung versetzte Löcher 10 mit gleicher X-Position aufweist. Der Laserstrahl wird auf die X-Position der beiden Löcher 10 eingestellt und dann in einer in Y-Richtung verlaufenden geraden Bahn **32** über die Mehrlagenleiterplatte 30 abgelenkt, so daß die beiden Löcher 10 überstrichen werden.

**Fig. 5** zeigt eine weitere Mehrlagenleiterplatte **40**, deren äußere Kupferschicht 41 mehrere zu vertiefende Löcher 10 aufweist, die jeweils auf zwei nicht parallelen Geraden liegen. Entlang dieser beiden Geraden werden die Bahnkurven **42**, **43** des Laserstrahls gewählt, so daß alle Löcher 10 in nur zwei Vorgängen überstrichen werden.

Bei der in **Fig. 6** gezeigten Mehrlagenleiterplatte **50** weist die äußere Kupferschicht **51** drei nicht auf einer Gerade liegende, zu vertiefende Löcher 10 auf. Die Bahnkurve **52** des Laserstrahls wird entlang der zu vertiefenden Löcher 10 zickzackförmig gewählt, so daß alle Löcher 10 in einem einzigen Vorgang überstrichen werden.

## Patentansprüche

1. Verfahren zum Vertiefen von Löchern (10), die in der äuβeren Kupferschicht (7; 21; 31; 41; 51) einer Mehrlagenleiterplatte (6; 20; 30; 40; 50) vorgesehen sind, in eine angrenzende Dielektrikumschicht (9) hinein mittels eines die Dielektrikumschicht (9) abtragenden Laserstrahls (2), **dadurch gekennzeichnet,**
**daß** der Laserstrahl (2) in mindestens einer, mindestens ein zu vertiefendes Loch (10) überstreichenden Bahnkurve (17; 22; 32; 42, 43; 52) über die äußere Kupferschicht (7; 21; 31; 41; 51) abgelenkt wird.

2. Verfahren nach Anspruch 1, **dadurch gekennzeichnet, daß** der Laserstrahl (2) in mehreren, jeweils mindestens ein anderes zu vertiefendes Loch (10) überstreichenden geradlinigen Bahnen (17; 42, 43) über die äußere Kupferschicht (7) abgelenkt wird.

3. Verfahren nach Anspruch 2, **dadurch gekennzeichnet, daß** die mehreren geradlinigen Bahnen (17) des Laserstrahls (2) auf der äußeren Kupferschicht (7) zueinander parallel verlaufen.

4. Verfahren nach einem der vorhergehenden Ansprüche, **dadurch gekennzeichnet, daß** der Laserstrahl (2) die äußere Kupferschicht (7) zumindest nahezu vollflächig überstreicht.

5. Verfahren nach Anspruch 2, **dadurch gekennzeichnet, daß** die mehreren geradlinigen Bahnen (42, 43) des Laserstrahls (2) auf der äußeren Kupferschicht (41) zueinander nicht parallel verlaufen und auf jeder geradlinigen Bahn (42, 43) jeweils mehrere zu vertiefende Löcher (10) überstrichen werden.

6. Verfahren nach einem der vorhergehenden Ansprüche, **dadurch gekennzeichnet, daß** der Laserstrahl (2) in Richtung auf die äußere Kupferschicht (7; 21; 31; 41; 51) zweidimensional abgelenkt wird.

7. Verfahren nach einem der Ansprüche 1 bis 5, **dadurch gekennzeichnet, daß** die Mehrlagenleiterplatte (6) am Laserstrahl (2) vorbeitransportiert wird und der Laserstrahl (2) schräg zur Transportrichtung (16) der Mehrlagenleiterplatte (6) abgelenkt wird.

8. Verfahren nach einem der vorhergehenden Ansprüche, **dadurch gekennzeichnet, daß** die Geschwindigkeit (v), mit welcher der Laserstrahl (2) die äußere Kupferschicht (7) überstreicht, und die Leistung des Laserstrahls (2) derart gewählt werden, daß in der Dielektrikumschicht (9) die gewünschte Lochtiefe in einem einzigen Überstreichungsvorgang erzielt wird.

9. Vorrichtung (1) zum Durchführen des Verfahrens nach einem der vorhergehenden Ansprüche, mit einem zur Abtragung der Dielektrikumschicht (9) geeigneten Laserstrahl (2), **gekennzeichnet durch** eine Ablenkeinrichtung, die den Laserstrahl (2) auf der äußeren Kupferschicht (7; 21; 31; 41; 51) bei einer während der Bearbeitung transportierten Mehrlagenleiterplatte (6) schräg zur Transportrichtung (16) oder bei einer während der Bearbeitung nicht transportierten Mehrlagenleiterplatte (20; 30; 40; 50) zweidimensional ablenkt.

10. Vorrichtung nach Anspruch 9, **dadurch gekennzeichnet, daß** die Ablenkeinrichtung einen rotierenden Polygonspiegel (4) umfaßt, der den Laserstrahl (2) zumindest radial zur Rotationsachse (13) ablenkt.

11. Vorrichtung nach Anspruch 9, **dadurch gekennzeichnet, daß** die Ablenkeinrichtung einen um zwei nicht parallele Achsen auslenkbaren Ablenkspiegel umfaßt, der den Laserstrahl (2) zweidimensional ablenkt.

12. Vorrichtung nach Anspruch 9, **dadurch gekennzeichnet, daß** die Ablenkeinrichtung zwei jeweils um eine Achse auslenkbare Ablenkspiegel umfaßt, wobei die Achsen nicht parallel zueinander verlaufen.
